# EUROPEAN PATENT APPLICATION

(11) **EP 4 365 938 A1**
(43) Date of publication of application: **08.05.2024**
(21) Application number: 22832486.9
(22) Date of filing: 17.03.2022
(51) Int. Cl.: H01L 23/36, H01L 23/373, H01L 21/52

(54) **JOINING MEMBER**

(30) Priority: 30.06.2021 JP 2021108335
(71) Applicant: Superufo291 Tec, Kyoto-shi, Kyoto 604-0924 (JP)
(72) Inventor: FUKUI, Akira, Kyoto-shi, Kyoto 604-0924 (JP); FUKUI, Toshie, Kyoto-shi, Kyoto 604-0924 (JP)
(74) Representative: Hoeger, Stellrecht & Partner Patentanwälte mbB
(86) International application number: PCT/JP2022/012287
(87) International publication number: WO 2023/276323

(57) **Abstract**

A bonding member includes a layered body (10) formed by layering a plurality of foils (11) made of a material selected from Au, Ag, Cu, Al, Ni, Sn, Zn, Mg, Pb, and an alloy of two or more of these metals, which are metals having high heat conductivity, the layered body having a void (12) of 5 vol% or more and 30 vol% or less inside, in which thermal conductivity after a power cycle test in which heating to 200 °C and cooling to 25 °C are repeated 300 times is 30 W/m·K or more.

## Description

### TECHNICAL FIELD

The present invention relates to a bonding member. In particular, the present invention relates to a bonding member that can be suitably used for bonding between a metal member used as an electrode substrate or the like in a semiconductor module such as an IGBT module and a ceramic member used as an insulating substrate or the like.

### BACKGROUND ART

In modern society, semiconductor modules are widely used and have become indispensable to society as their use is further expanded. Their use is being further expanded such as use in particular in electric vehicles. In addition, with the spread of use, further downsizing and high performance of the semiconductor module are being sought. One of the elements to be sought in electric vehicles is an IGBT module. In the IGBT modules, a shift from Si semiconductor devices to SiC semiconductor devices are underway.

Early-time IGBT module in an electric vehicle is one developed for trains and modified for an electric vehicle. Such IGBT module is a module in which a Si semiconductor device, a direct bonded cupper (DBC)/direct bonded aluminum (DBA) substrate (obtained by physically bonding, by brazing, a metal electrode layer to an upper face of a ceramic plate, and physically bonding, by brazing, a metal layer to be balanced with the metal electrode layer to a lower face) and a heat release substrate (AlSiC, CuMo) are physically bonded by solder, and the heat release substrate and a cooler (metal fin) are further chemically bonded by a silicone-resin based thermal contact adhesive (also referred to as "thermal grease"). This is what is called a single-sided cooling type in which heat generated from the Si semiconductor device is cooled from one side. This module has six bonded portions between the Si semiconductor device and the cooler.

Later, a structure called a single-sided direct cooling type has been started to be adopted. In a single-sided direct cooling type IGBT module, a method has been adopted in which a Si semiconductor device and a DBA substrate are physically bonded by solder, and a DBA substrate and a cooler are physically bonded by a punched Al alloy plate and an Al brazing material. In this module, it has been possible to omit the heat release substrate and the silicone-resin based thermal contact adhesive, but there are still five bonded portions. In addition, in this structure, the procedure of bonding at the time of manufacturing is complicated.

In addition, in another module called a single-sided direct cooling type, a method has been adopted in which a Si semiconductor device, a DBC substrate, and a cooler are physically bonded by solders having different bonding temperatures. Also in this module, it has been possible to omit the heat release substrate and the silicone-resin based thermal contact adhesive, but there are still four bonding layers. In addition, in a heat cycle test in which heating and cooling are repeated assuming the operation of the semiconductor device, a load is applied to the DBC substrate. Therefore, there is a limit to achieving both downsizing and high performance.

In these types of methods, there has been a problem in that, an expensive DBA/DBC substrate must be used and the cost is high, and additionally, since the DBA/DBC substrate is obtained by bonding Al/Cu electrodes to both faces of a ceramic plate, performing a heat cycle test on the assumption that the operating temperature of a semiconductor device is high causes peeling off of bonding interface between the Al electrode or the Cu electrode and the ceramic.

Later, a structure called a double-sided cooling type has been proposed. In the double-sided cooling type IGBT module, the semiconductor device and the Cu electrode substrate are physically bonded by soldering, and each of the Cu electrode substrate and the insulating substrate, and the insulating substrate and the cooler are chemically bonded with a silicone-resin based thermal contact adhesive. In the double-sided cooling type IGBT module, cooling efficiency is improved by cooling the semiconductor device from both upper and lower sides. In addition, since an expensive DBC/DBA substrate is not used, it is possible to suppress the cost. However, the thermal conductivity of the silicone-resin based thermal contact adhesive is as low as 1 W/m·K, and the silicone-resin based thermal contact adhesive is cooled from both faces in order to take measures to reduce the thermal resistance, so that the number of members increases. In addition, there are a total of six bonded portions sandwiching the semiconductor device from the upper and lower sides. This is the same as the number of bonded portions in the initial single-sided cooling type module or the single-sided direct cooling type module.

Recently, a shift to a SiC semiconductor device having an operating temperature higher than that of a Si semiconductor device is underway. In an IGBT module on which a SiC semiconductor device is mounted, a single-sided cooling type structure or a double-sided cooling type structure has been studied in which a SiC semiconductor device and a Cu electrode provided on a DBC substrate are bonded to each other by nano Ag, and a DBC substrate and a cooler are bonded to each other by a silicone-based thermal contact adhesive.

In addition, in Patent Literature 1, the inventors of the present invention have proposed a new die bond bonding member that can be suitably used for bonding a Si/SiC semiconductor device and a Cu electrode substrate.

### CITATION LIST

### PATENT LITERATURE

Patent Literature 1: JP 6803106 B1

### NON PATENT LITERATURE

Non Patent Literature 1: Naoto Shioi, "Silver Paste with High Thermal Conductivity", HARIMA TECHNOLOGY REPORT, NO. 110, 2012 WINTER, [Searched on June 7, 2021], Internet <URL: https://www.harima.co.jp/images/uploads/20120120183114_a64ald4b447caccd25e2f219e 82c38a2.pdf>
Non Patent Literature 2: Daisuke Hashimoto, Yukiya Nomura, "Thermal Properties of Copper Alloys for Electronic Electrical Components", Kobe Steel Engineering Reports, Vol. 65, No. 2, Sep. 2015

### SUMMARY OF INVENTION

### TECHNICAL PROBLEM

Silicone-resin based thermal contact adhesives used for bonding between a Cu electrode substrate on which a semiconductor device is mounted and an insulating substrate, and between an insulating substrate and a cooler are flexible, and appropriately deformed in accordance with uneven portions and inclination of a surface of a member to be bonded, and thus are widely used. The insufficient bonding strength in the case of using the silicone-resin based thermal contact adhesive is solved by screwing (single-sided cooling type) or applying a load to the module (double-sided cooling type). However, as described above, the thermal conductivity of the silicone-resin based thermal contact adhesive (containing alumina fillers in silicone resin) is as low as about 1 W/m·K, and heat transfer is poor because of high thermal resistance. There is also a problem in that an adhesive leaks from a bonded portion due to a pump-out phenomenon or a material deteriorates after a heat cycle test.

Not limited to the IGBT module, when a member having at least a metal bonding face and a member having at least a ceramic or resin bonding face are bonded, there is a difference in linear expansion coefficient between the materials constituting the bonding faces. Therefore, when these members are bonded to constitute a heat release path, various problems occur.

An object of the present invention is to provide a bonding member capable of improving heat release efficiency of a heat release path constituted by bonding a member whose bonding face is metal and a member whose bonding face is ceramic or resin.

### SOLUTION TO PROBLEM

In a part of the IGBT module, an electric path and a heat release path (heat path) are common. Regarding die bonding for bonding a semiconductor device and an electrode substrate, by using nano-Ag or a bonding member corresponding to the invention described in Patent Literature 1 by the inventors of the present invention, directionality of bonding is being clarified. Therefore, the inventors of the present invention have studied a bonding member capable of improving heat release efficiency in a heat release path from the electrode substrate to the cooler. Hereinafter, details will be described of a bonding member, studied by the inventors of the present invention, for constituting a heat release path by bonding members having different linear expansion coefficients, such as a member whose bonding face is metal and a member whose bonding face is ceramic or resin.

A semiconductor module is a device having a precise and complicated structure, and it is required to reduce the number of components and bonded portions for bonding the components and to improve the performance and characteristics of the components and the bonded portions. Conventionally, in the process of achieving both downsizing and high performance, the number of various types of members constituting the heat release path from the electrode substrate to the cooler has been minimized. In addition, as a method for bonding the various types of members, a method that achieves cost effectiveness has been put into practical use.

The semiconductor device and the Cu electrode substrate provided on the DBC substrate are physically bonded (die bonded) by solder. Furthermore, a balance Cu plate (plate provided to balance with the Cu electrode) on the lower face of the DBC substrate and the heat release substrate are also physically bonded by solder. The heat release substrate and the cooler are chemically bonded by thermal contact using a silicone-based resin material. In addition, a Cu electrode substrate provided on a DBC substrate and a cooler are directly soldered. The expensive DBC substrate is an integral member including a Cu electrode/ceramic substrate/balance Cu plate, and has been regarded as a very important member that separates the electric path and the heat path. The balance Cu plate is necessary for manufacturing the DBC substrate, but is not necessary as a heat path.

In the past, it was considered that a DBA substrate or a DBC substrate in which functions of electric conductance by a Cu electrode and insulation by a ceramic substrate were integrated was indispensable for an IGBT module for electrically-powered vehicles (for EV or the like). However, in the DBA/DBC substrate, it is necessary to attach a balance Cu plate on the lower side of the ceramic substrate in order to reduce warpage that occurs when the electrode is attached at the time of manufacturing, and thus the DBA/DBC substrate is an expensive member. In addition, there is a problem in that the interface between the Cu electrode and the ceramic substrate is peeled off or the ceramic is damaged due to the heat cycle test. Currently, in order to reduce the cost of the module, manufacturers have been conducting development for downsizing, high performance, and high quality.

In home electric appliances with which price competition is severe, there have already been put into practical use IGBTs in which a Cu electrode to which a semiconductor device is attached, an insulating (made of ceramic or resin) substrate, and a member having a combined function of a circuit substrate are chemically bonded with a silicone-resin based thermal contact adhesive.

Under such circumstances, there has been put into practical use an IGBT having a new structure in which a Cu electrode and a ceramic substrate are separated from each other in a double-sided cooling type structure on which a Si semiconductor device is mounted, a balance Cu plate on a lower face of the ceramic substrate is omitted, and the Cu electrode with the Si semiconductor device and the ceramic substrate as well as the ceramic substrate and a cooler are bonded by a silicone-resin based thermal contact. However, in electrically-powered vehicles (EV, HEV, etc.), required performance, life, and quality are greatly different from those of home electric appliances. Therefore, when a silicone-resin based thermal contact having a low thermal conductivity is used as a bonding member, it is necessary to use the double-sided cooling type in order to enhance heat release performance. By adopting the double-sided cooling type, the heat release paths are arranged in parallel, and the heat release effect is improved, while the number of constituent members and the number of bonded portions are increased.

Thereafter, in the double-sided cooling type structure on which the SiC semiconductor device is mounted, development has been conducted returning to a structure in which the die bond is changed from solder to nano Ag, and the DBC substrate is restored, and the balance Cu plate on the lower face of the DBC substrate and the cooler are bonded by a silicone-resin based thermal contact adhesive, and the results have been reported. The reason why the DBC substrate was restored with this structure is that, when a heat cycle test assuming heat generation of a SiC semiconductor device is performed on an IGBT in which each of a Cu electrode and a ceramic substrate, and the ceramic substrate and a cooler is bonded by silicone-resin based thermal contacts, the silicone-resin based thermal contact adhesive becomes excessively soft due to an increase in temperature of a bonded portion between the Cu electrode and the ceramic substrate, and leaks out due to a pump phenomenon, and the bonded portion is deteriorated, and further, the thermal conductivity is too low to perform sufficient heat release.

In consideration of the heat path of the heat release path from the electrode substrate of the IGBT module to the cooler taking such reason into account, it is considered that the problem of the silicone-resin based thermal contact adhesive is leakage and deterioration of the adhesive due to the pump phenomenon at a high temperature and an excessively low thermal conductivity. The directionality of solving the above problems by improving these points has been clarified.

There are various resin thermal contact adhesives, and what is called a chemical bonding product and used for bonding between members in an IGBT module is a silicone-based resin in which fillers having a high thermal conductivity are dispersed. For example, alumina fillers having high thermal conductivity are brought into contact with a silicone-based resin, and such fillers are connected in the Z-axis direction (direction perpendicular to the bonding face of the bonding member) to improve the thermal conductivity. Since such a thermal contact adhesive is flexible, the thermal contact adhesive easily enters uneven portions on the surface of the member to be bonded, and it is possible to obtain an effect of alleviating thermal stress caused by a difference in linear expansion coefficient (linear expansion coefficient of Cu: 17 ppm/K, AlN ceramic: 4 to 5 ppm/K, DBC/DBA: 7 to 9 ppm/K) between the bonding members. On the other hand, the heat-resistant temperature is as low as about 150 °C, and the thermal conductivity is also as low as 1 W/m·K (silicone-based resin itself is 0.1 W/m K, alumina is 17 to 24 W/m K, and solder is about 23 W/m K.). Furthermore, there is a problem in that an adhesive leaks due to the pump-out phenomenon, a bonded portion is hollowed, and a resin material is deteriorated when a heat cycle test assuming a semiconductor device operating at a high temperature is performed. In addition, the alumina fillers are mechanically bonded by being continuously brought into contact in the Z-axis direction, and the fillers as such hardly contribute to the bonding strength. Chemical bonding performed using a silicone-based resin has insufficient strength, and a method of screwing or a method of applying a load to the entire module is adopted in order to stabilize the bonded state in the module. A thermal contact adhesive of a silicone-based resin is a product achieved by mechanical bonding of alumina fillers and chemical bonding of a resin.

In order to solve the problem of the resin adhesive, conventionally, various types of resins and fillers and various amounts of fillers have been proposed. Under such circumstances, it has been studied to increase the thermal conductivity by dispersing a large amount of Ag fillers in an epoxy resin for use in LED lighting (for example, Non Patent Literature 1).

Non Patent Literature 1 proposes an adhesive in which Ag fillers having a particle size of about 1 µm are dispersed in a resin at a volume fraction of 70 vol% or more to secure thermal conductivity, and an epoxy resin is cured to secure bonding strength. The Ag fillers are not sintered and bonded at the curing temperature of the epoxy resin. The Ag fillers are merely in physical contact and necking, and hardly contribute to the bonding strength. The epoxy resin has a thermal conductivity of 0.3 W/m·K. The bonding strength is based on an epoxy resin, the thermal conductivity is based on a series of necked Ag fillers in the Z-axis direction, and the members are characterized by a combination of the epoxy resin and the Ag fillers.

In such a resin adhesive, it is said that the thermal conductivity is greatly improved by increasing the volume fraction (vol%) so that the Ag filler particles are in contact with each other. This suggests that a certain degree of thermal conductivity can be secured when the fillers come into contact with each other and are appropriately connected. However, depending on the shape of the fillers, the thermal conductivity does not necessarily increase in proportion to the amount of the Ag fillers (the fillers are not arranged so as to be in linear contact with each other in the Z-axis direction, and the thermal conductivity can vary depending on the state of the contact point or the like). In order to maintain the shape of the bonding member, it is necessary to use a certain amount or more of a resin material, and such use makes it difficult to further significantly improve the thermal conductivity. In addition, since the cured epoxy resin has a large linear expansion coefficient and is hard and brittle, when a heat cycle test at a high temperature is performed, peeling or destruction occurs due to deterioration of the materials, and it is difficult to use such a resin adhesive in a high-performance IGBT module.

Based on the above points and the knowledge on the invention of the new die bond proposed by the inventors of the present invention in Patent Literature 1, the inventors of the present invention have invented a bonding member capable of securing thermal conductivity of a necessary magnitude after performing a heat cycle test assuming a high-performance IGBT module.

In the bonding member of the present invention, it has been considered desirable that the bonding member has a stress-alleviating structure with less material deterioration so that the member to be bonded can be bonded by modifying or correcting variation in surface accuracy of the member to be bonded without necessarily depending on the resin material and can withstand a heat cycle test. It has been considered that there is no problem as long as the bonding strength and the bonded state can be secured by applying a load from the outside of the bonding member to the bonding member that secures a certain volume fraction (vol%) or more. Then, obtaining a thermal conductivity of 30 W/m K or more after the heat cycle test was defined as a requirement required for the new bonding member.

A bonding member according to the present invention made to solve the above problems includes:
a layered body formed by layering a plurality of foils made of a material selected from Au, Ag, Cu, Al, Ni, Sn, Zn, Mg, Pb, and an alloy of two or more of these metals, the layered body having voids of 5 vol% or more and 30 vol% or less inside, in which
thermal conductivity after a power cycle test in which heating to 200 °C and cooling to 25 °C are repeated 300 times is 30 W/m·K or more.

The bonding member according to the present invention is typically used for bonding a member having a metal bonding face and a member having a ceramic bonding face to constitute a heat release path. Specifically, for example, in an IGBT module, a Cu electrode substrate and a ceramic substrate, and/or a ceramic substrate and a cooler are bonded to constitute a heat release path. The member to be bonded is not limited to these, and the bonding member according to the present invention can be suitably used also when bonding metal members or bonding a resin member (for example, an insulating resin sheet).

The bonding member according to the present invention is constituted by layering a plurality of foils made of a material selected from Au, Ag, Cu, Al, Ni, Sn, Zn, Mg, Pb, and an alloy of two or more of these metals, which are metals having high thermal conductivity. The plurality of foils may be the same material or different materials. By layering and using foil-shaped metal, flexibility can be imparted, and the bonding member can be brought into close contact with uneven portions or the like on the surface of the member to be bonded. In addition, by confining the bonding member formed by layering the foils in a closed space and applying a load, an effect (spring effect) of each foil acting like a spring is obtained, whereby the foils are stably kept in contact with each other, and heat is transmitted in the Z-axis direction.

In the present invention, the bonded state of the heat release path (heat path) can be maintained by the layered body without using the resin thermal contact adhesive as described above. Furthermore, by adopting a structure having voids of 5 vol% or more and 30 vol% or less inside the layered body, it is possible to alleviate thermal stress caused by a difference in linear expansion coefficient between members to be bonded. When the voids are less than 5 vol%, it is difficult to obtain sufficient flexibility to alleviate thermal stress, and when the voids are more than 30 vol%, it is difficult to obtain sufficiently high thermal conductivity. Furthermore, even if there is a difference in linear expansion coefficient between the members to be bonded, the contact point between the foils slides during the heat cycle test to alleviate the stress caused by the difference in linear expansion coefficient, and the bonded state is stabilized to enable transfer of heat. In addition, since the thermal conductivity is 30 W/m K or more after a power cycle test in which heating to 200 °C and cooling to 25 °C are repeated 300 times, even when a semiconductor device operating at a high temperature is mounted, the heat can be efficiently released to make it possible to constitute a highly reliable IGBT module.

In order to ensure operation reliability of the bonding member used in the IGBT module, evaluation of characteristics of the bonding member is important. The surest way to evaluate the characteristics is that an IGBT module is actually manufactured and mounted on an actual machine or a vehicle to be tested. However, it takes time and cost to actually produce an IGBT module every time the bonding member is tested, and it is not practical to mount an IGBT module on an actual machine or a vehicle to be tested. As a method for evaluating characteristics of a bonding member, for example, a method has been conventionally adopted in which an X-ray image or an SEM image of a bonded portion is acquired before and after a fracture test, and the images are compared with each other for bonding strength, but there is no method established yet.

Naturally, manufacturers of electrical machines, electric machines, or automobiles do not incorporate a bonding member according to the present invention into an IGBT module to perform evaluation unless physical validity in the characteristics and performance of the present invention is shown. Hitherto, in die bonding, bonding strength before and after a heat cycle test, an X-ray image, and an SEM image have been mainly targets of evaluation, but what is actually desired is thermal conductivity before and after the heat cycle test. However, conventionally, there is no good method for evaluating the thermal conductivity.

Conventionally, in an IGBT module using a silicone-resin based thermal contact adhesive as a bonding member, a heat release substrate and a cooler are screwed to secure bonding strength, and a load is applied from above and below the IGBT module. Therefore, it is considered that there is no particular problem in adopting a method of screwing or applying a load for the bonding member according to the present invention as in the case of using the silicone-resin based thermal contact adhesive.

Also in the present invention, there may be a case where the bonding member is used with a certain load applied to the bonding member. In this case, a layered body of foils having voids of 5 vol% or more and 30 vol% or less inside is disposed in a space in which the peripheral portion is restrained, and a heat cycle test is performed in a state where a load is applied, and characteristics and a bonded state after the heat cycle test are confirmed.

As a method for evaluating the thermal conductivity of a sample, for example, a laser flash method is known. However, the measurement value by the laser flash method depends on the shape and dimensions of the sample. Therefore, if a jig for applying a load or a jig for ensuring the volume fraction (vol%) of the foils is attached, it is impossible to measure the thermal conductivity.

The inventors of the present invention have noticed the Wiedemann-Franz law, and attempted to evaluate the thermal conductivity with a jig. The Wiedemann-Franz law represents that the thermal conductivity and electrical conductivity of a metal are proportional to each other, and is considered to be established regardless of the composition, internal structure, or the like of an object. Non Patent Literature 2 recites that the thermal conductivity is calculated from the electrical conductivity (IACS%) of the sample using this law. The electrical conductivity (IACS%) may be measured by eddy current using a sigma tester with a probe having a diameter of about 5 mm in contact with a sample, and can also be used for measuring the thermal conductivity of the bonding member according to the present invention. By this method, the degree of sintering of imprinted metal powder and the defect detection of the bonding layer between the metals are performed.

However, for ceramic having an electrical insulation property, it is impossible to measure the thermal conductivity with a sigma tester. Therefore, it is impossible to measure as it is the thermal conductivity of the bonded body obtained by bonding the electrode member or the cooler and the ceramic substrate using the bonding member according to the present invention. Therefore, the thermal conductivity of the bonding member according to the present invention has been evaluated using a plate of tungsten (W), which is a metal having a linear expansion coefficient and thermal conductivity similar to those of ceramic, instead of the ceramic substrate.

### ADVANTAGEOUS EFFECTS OF INVENTION

By using the bonding member according to the present invention, it is possible to improve the heat release efficiency when a metal member and a ceramic member are bonded to constitute a heat release path.

### BRIEF DESCRIPTION OF DRAWINGS

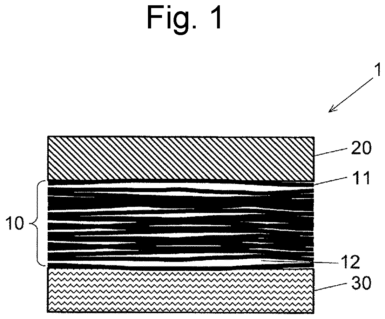

[Fig. 1] Fig. 1 is a schematic configuration diagram of a bonded body including an embodiment of a bonding member according to the present invention.

### DESCRIPTION OF EMBODIMENTS

A bonding member according to the present invention is used for bonding two members to be bonded selected from a metal member, a ceramic member, and a resin member. Typical examples of these members to be bonded are members used in an IGBT module, but are not limited to such members, and may include members used in other semiconductor modules other than IGBT modules and members used in other than semiconductor modules. In particular, the bonding member according to the present invention is suitably used for bonding a metal electrode substrate on which a semiconductor device is mounted and a ceramic insulating substrate, or for bonding the insulating substrate and a metal cooler.

The technical idea of the present invention is to solve the above problems by following good points of a conventional thermal contact adhesive in which fillers are dispersed in silicone resin.

The bonding member of the present invention is characterized by being capable of solving the above problems related to the conventional thermal contact adhesive, and having a thermal conductivity of 30 W/m·K or more after 300 times of heat cycle tests in which cooling and heating are repeated in a temperature range of 25 °C to 200 °C. In order to achieve this, the bonding member according to the present invention is constituted by layering a plurality of foils made of Au, Ag, Cu, Al, Ni, Sn, Zn, Mg, Pb, and an alloy of two or more of these metals, which are metals having high thermal conductivity, and has voids of 5 vol% or more and 30 vol% or less inside.

The inventors of the present invention have considered using a metal foil in studying the bonding member according to the present invention. The metal has the same electrical conductivity, thermal conductivity, and linear expansion coefficient as those of the platelike metal even if the metal is in the form of foil or powder.

However, the metal in the form of powder cannot maintain its shape by itself, and needs to be compression-molded at high pressure, and the smaller the particles, the greater the pressure needs to be applied. In addition, even if compression molding is performed, the powder is likely to be chipped off from the ends. Furthermore, even if the outside of the powder is restrained, unless the volume fraction (vol%) is 100%, voids are generated in the upper portion during a heat cycle test or vibration, and heat is not conducted. In order to produce a bonding member having a volume fraction (vol%) of 100% from a powder material, it is necessary to apply an extremely high load.

On the other hand, a foil-shaped member alone has a certain shape. In addition, chipping hardly occurs, and the thermal conductivity in the horizontal direction (direction along the surface of the foil) is the same as that of the plate member. Even when pressure is applied in order to constitute a layered body, a lower pressure is sufficient as compared with compression molding of powder, and heating at the time of compression can further suppress the pressure. In addition, it is possible to obtain high thermal conductivity also in the layering direction (Z-axis direction) by appropriately adjusting the pressure and temperature applied at the time of compression. In addition, in a case where the thermal conductivity is insufficient, the thermal conductivity is improved by using a bonding member subjected to, as preparation, sintering of a contact portion between the foils by applying a load to the layered foils before bonding, or a bonding member subjected to welding to form a contact portion between the foils. In addition, there is no problem even if these are combined with the foil.

Since a member in which foil-shaped members are layered has flexibility, such member is deformed according to the shape of uneven portions or the like on the surface of the member to be bonded to adhere to the uneven portions, and makes it possible to reduce the influence of the uneven portions. Therefore, it is necessary to dispose one foil for each member to be bonded, and it is necessary to provide at least two (that is, a plurality of) foils as the entire bonding member. The intended effect described above cannot be obtained with only one sheet. In addition, by increasing or decreasing the number of foils to be partially layered, it is possible to constitute a bonding member in which the thickness is partially changed according to the distance between faces to be bonded. In addition, there is no problem in dividing the foils as long as the effect of the foils described in the present specification remains.

Since the voids are provided inside the bonding member, it is possible to alleviate thermal stress caused by a difference in linear expansion coefficient between the members to be bonded. The ratio of voids may be appropriately increased or decreased in consideration of the difference in thermal stress that may occur between the members to be bonded and the value of thermal conductivity. In general, the larger the difference in linear expansion coefficient is, the higher the void rate may be (the smaller the volume fraction is), or the more foils may be layered. The contact portion of the foils slides during the heat cycle test, and has an effect of alleviating stress. These phenomena occur in combination or individually, ensuring the required thermal conductivity values and alleviating thermal stress.

As described above, the foils have a spring effect, and when a load is applied by placing a lid on the layered body in a state where the outer periphery is restrained, the contact state in the layering direction is further stabilized, and even if floating occurs in the contact portion between the foils, the contact portion is repaired. In addition, the contact portion of the foils is loaded even when sliding occurs during the heat cycle test. The magnitude of the spring effect of the foils can also be adjusted by appropriately setting the volume fraction.

In an embodiment of the present invention, a layered body 10 is produced by being subjected to heating and pressurizing in a non-oxidizing atmosphere. Fig. 1 is a schematic view illustrating a structure of a bonded body 1 in which members to be bonded 20, 30 are bonded by a bonding member including the layered body 10. In this bonding member, the contact portions between metal foils 11 are bonded to each other, and voids 12 are formed at portions other than the contact portions. The schematic view of Fig. 1 schematically illustrates the thickness of the metal foil 11 and the positions and sizes of the voids 12, and the ratio of the sizes to the members to be bonded 20, 30 may be different from the actual size. The method for producing the layered body is not limited to the above-mentioned method, and it is possible to adopt any production method as long as the requirements of the present invention, such as a thermal conductivity after the heat cycle test of 30 W/m·K or more, are satisfied.

The thickness of each metal foil 11 is preferably 0.1 µm or more and 100 µm or less. If the thickness is less than 0.1 µm, the film is easily broken, and it becomes difficult to maintain the foil shape. On the other hand, if the thickness is larger than 100 µm, it is difficult to obtain flexibility. The thickness of the metal foils 11 to be laminated may be uniform or may be different. For example, when a thick metal foil 11 is used at the central portion of the layered body 10 and a thin metal foil 11 is used on the front and back faces, the front and back faces of the layered body are easily deformed according to the uneven portions of the surface of the member to be bonded while increasing the thermal conductivity (for example, Example 2 described later). The metal foils 11 do not need to have such a size as to cover the entire bonding faces of the members to be bonded 20, 30, and a plurality of metal foils 11 may be used side by side in the lateral direction (in a direction perpendicular to the layering direction). Furthermore, the metal foil 11 may be partially provided with a hole. By using the metal foil 11 (including net-like metal foil) provided with such holes, Young's modulus can be lowered to enhance the flexibility of the layered body 10.

A bonding member according to an embodiment of the present invention is used for bonding the members to be bonded 20, 30, which are a combination of any two of a metal member, a ceramic member, and a resin member (including a combination of the same kind of members such as metal members). It is possible to suitably use the bonding member according to an embodiment of the present invention especially for bonding a ceramic member having no wettability to solder (therefore, solder cannot be used as a bonding member.). Even when it is possible to use another bonding member such as solder or the like, in many cases, a defect (peeling, cracking, etc.) occurs in the bonded portion when a power cycle test in which heating to 200 °C and cooling to 25 °C are repeated 300 times is performed. On the other hand, in the bonding member of the present invention, no defect occurs after a power cycle test in which heating to 200 °C and cooling to 25 °C are repeated 300 times, and the bonding member has a thermal conductivity of 30 W/m·K or more, so that operation stability at the time of mounting to an IGBT module or the like is secured.

In the IGBT module, the bonding face of the Cu electrode substrate or the ceramic substrate usually has flatness and parallelism of a certain degree or more. On the other hand, the accuracy of the bonding face of the cooler (metal fin) is not so high, and for example, the flatness is about 10 µm at the maximum. Similarly, the parallelism with respect to the bonding face of the ceramic substrate bonded to the cooler is also about 100 µm at the maximum. In one embodiment of the present invention, the number of foils to be layered can be appropriately changed according to the flatness of the bonding face and the parallelism between the bonding faces of the bonding member. Specifically, when the flatness of the bonding faces and the parallelism between the bonding faces of the bonding members 20, 30 are low, the number of the metal foils 11 may be increased so as to be able to sufficiently absorb the low flatness and parallelism. In addition, even when the difference in linear expansion coefficient between the members to be bonded 20, 30 is large, the number of metal foils 11 may be appropriately increased so that a large thermal stress generated between the members to be bonded 20, 30 can be absorbed. It is preferable that the entire thickness of the layered body 10 is 3 µm or more and 500 µm or less. If the thickness of the layered body 10 is less than 3 µm, it is difficult to obtain flexibility enough to alleviate thermal stress. On the other hand, when the thickness of the layered body 10 exceeds 500 µm, it is difficult to obtain a sufficient heat release effect.

In each embodiment of the bonding member according to the present invention, even when the face accuracy (flatness) of the member to be bonded or the parallelism between the bonding faces of the member to be bonded is poor due to flaws or the like, the foil is restored by being brought into close contact with uneven portions or the like present on the surface of the members to be bonded, and the performance and characteristics are secured. In addition, it is possible to obtain the thermal conductivity 30 times that of the silicone-resin based thermal contact adhesive that has been conventionally used. As long as the performance and characteristics required as a bonding member in a semiconductor module are satisfied, the metal foil 11 is not necessarily in complete contact with the entire surfaces of the members to be bonded 20, 30. In addition, when the contact area between the members to be bonded 20, 30 and the metal foil 11 is reduced or the number of the metal foils 11 is reduced, heat generated from the semiconductor device flows through a portion having low thermal resistance (a portion having high thermal conductivity). Furthermore, in one embodiment of the present invention, in order to restore the uneven portions of the bonding faces of the members to be bonded 20, 30 and the parallelism between the bonding faces of the members to be bonded 20, 30, a resin having high thermal conductivity (low thermal resistance) or a filler-containing resin may be disposed at the bonding portion with the members to be bonded 20, 30. Reducing the amount of foil used while securing performance and characteristics also leads to cost reduction.

In another embodiment of the present invention, a metal film is formed by depositing or plating metal on the bonding faces of the members to be bonded 20, 30. For example, when the layered body 10 made of a plurality of Ag foils is used as a bonding member, it is preferable to form a protective film made of Ni or the like for suppressing Ag atoms from entering the members to be bonded 20, 30. Even when it is not intended to function as a protective film, forming an appropriate type of metal layer on the appropriate bonding faces of the members to be bonded 20, 30 enables stabilization of the bonded state.

In still another embodiment of the present invention, when the depth of a concave portion present in the bonding face of the members to be bonded is as large as 10 µm or more, fillers for filling the concave portion or a mixture of a resin and fillers may be disposed to close the concave portion. In addition, even when the members to be bonded are largely warped or wavy, fillers or a mixture of a resin and fillers may be disposed to flatten.

A bonding member according to an embodiment of the present invention is used in an IGBT module. Pressure and temperature at the time of disposing and bonding the plurality of metal foils 11 between the Cu electrode substrate and the ceramic substrate and/or between the ceramic substrate and the cooler may be appropriately determined in consideration of characteristics such as flexibility required for the bonding member 10 within a range in which each component of the IGBT module is not damaged. The heating temperature at the time of bonding is preferably equal to or higher than a temperature that can reach during operation of the semiconductor device. In one embodiment, in a power cycle test in which heating to 200 °C and cooling to 25 °C are repeated, heating to 200 °C or higher is preferable in order to prevent the bonding member from being denatured. In addition, at the time of bonding, the periphery of the bonded portion may be surrounded by, for example, housing the outer periphery of the bonded body 10 in a case that restrains the outer periphery. Accordingly, it is possible to prevent the bonding member from protruding to the outside of the bonded portion. In addition, it is preferable to apply a load in the bonding direction by placing a lid or the like at the time of bonding. This improves the bonding strength. In addition, a foil of a first metal having a high melting point and a foil of a second metal having a low melting point may be layered in combination, and heated (and appropriately pressurized) to a temperature near the melting point of the second metal to partially melt the second metal, thereby melting and bonding the foils. It is possible to use, for example, Ag as the first metal, and to use, for example, Sn as the second metal (for example, Example 12 described later). Alternatively, when there is a possibility that a temperature and a pressure necessary for obtaining a layered body having desired characteristics cause damage to each component of the IGBT module, the layered body may be produced by applying a temperature and a pressure necessary only to a plurality of metal foils, and then the layered body may be disposed between members to be bonded, and the members to be bonded may be bonded at a temperature and a pressure within a range in which each component of the IGBT module is not damaged. In consideration of the possibility that the layered body is compressed in the process of final heating and pressurization and the void rate decreases, the volume fraction of the layered body produced first may be set within the range of 60 vol% or more and 95 vol% or less. In general, the larger the number of metal foils to be layered, the more the void rate decreases, so that the volume fraction of the layered body to be layered first may be reduced. If the finally obtained bonding member has voids of less than 5 vol%, it is difficult to obtain sufficient flexibility to alleviate thermal stress, and if the voids exceed 30 vol%, it is difficult to obtain sufficiently high thermal conductivity.

By using the bonding member of the above embodiment, it is possible to constitute the IGBT module at low cost without using an expensive DBC/DBA substrate. In addition, the number of foils to be used and the form of layering can be appropriately changed according to the required shape, and can be used for bonding the electrode substrate and the ceramic substrate and bonding the ceramic substrate and the cooler. Furthermore, damage does not occur after a heat cycle test reaching 200 °C, in which a bonded state cannot be maintained with solder or a silicone-resin based thermal contact adhesive, and thermal conductivity equal to or higher than that of solder can be obtained. In addition, the bonding member of each of the above embodiments can be used in either a single-sided cooling type or a double-sided cooling type. When the double-sided cooling type configuration is adopted, the heat release path is doubled. This makes it possible to change a conventional water-cooled IGBT module to an air-cooled IGBT module or produce an IGBT module incorporated in a motor.

Next, a method for evaluating the characteristics of the bonding member according to the present invention will be described. In the present embodiment, the thermal conductivity of the bonding member was calculated by measurement using a sigma tester. As described above, since it is impossible to measure the thermal conductivity of the ceramic having the electrical insulation property, a sample bonded to the Cu plate was formed using a plate of tungsten (W) (linear expansion coefficient 4.5 ppm/K, thermal conductivity 167 W/m·K) having a linear expansion coefficient and thermal conductivity close to those of the AlN ceramic (linear expansion coefficient 4 to 5 ppm/K, thermal conductivity 170 W/m·K) instead of the ceramic substrate, and the thermal conductivity was measured.

Specifically, first, two first members were produced in which holes for screwing were provided at corner portions of an alumina plate having a 40 mm square and a thickness of 2 mm, and a hole having a diameter of 10 mm was formed at a central portion. Next, a second member was produced in which holes for screwing were provided at corner portions of a polyimide plate having a 40 mm square and a thickness of 2 mm, and a hole having a diameter of 20 mm was formed at a central portion. Then, a sample was disposed in the hole at the center of the second member, and the outer periphery of the sample was restrained, and the second member was sandwiched between the first members from the upper and lower sides and screwed to produce a test piece. Then, the thermal conductivity of the entire sample was calculated on the basis of the Wiedemann-Franz law from the measured values of the electrical conductivity (IACS%) acquired by bringing the sigma tester into contact with the sample from each of the central holes of the first members disposed on the upper side and the lower side, and the thermal conductivity of the bonding member was calculated from the thermal conductivity of Cu (386 W/m·K) and the thermal conductivity of W (167 W/m·K). Thereafter, a power cycle test was performed in which heating to 200 °C and cooling to 25 °C were repeated 300 times, the bonded state after the test was confirmed, and the thermal conductivity was calculated again by the above method.

First, for six samples (Conventional Examples 1 to 6) corresponding to the conventional technology, the above test pieces are produced, and the results of evaluating the characteristics are described. Table 1 shows configurations and evaluation results of Conventional Examples 1 to 6.

**[Table 1]**

| Conventional Example | Bonding member | Bonding method | Before test | After test |
|---|---|---|---|---|
| 1 | Sn-based solder | Thermal bonding at 260 °C | Not bonded | |
| 2 | Ag brazing material | SPS bonding at 630 °C and 1 MPa | Not bonded | |
| 3 | Ag brazing material (containing Ti) | SPS bonding at 850 °C and 1 MPa | 178 | Peeling |
| 4 | Silicone-resin based thermal contact adhesive | Bonding at 25 °C | Unmeasurable | Peeling |
| 5 | 1 µm diameter Ag flake fillers are dispersed in epoxy resin. Volume fraction 75% | Heat curing at 210 °C | Unmeasurable | Peeling |
| 6 | 1 µm diameter Ag flake fillers only. Volume fraction 75% | Compressive bonding at 250 °C and 10 MPa | 33 to 65 | Cavitation |

In each of Conventional Examples, a Cu plate and a W plate (both have a diameter of 20 mm and a thickness of 1 mm) are bonded, and the members used for bonding and the bonding method are different. The thicknesses of the bonding members were all 100 µm. The SPS bonding in the table refers to bonding by a spark plasma sintering method. In addition, the volume fraction of 75% in Conventional Examples 5 and 6 is that there are voids of 25 vol% inside the bonding member.

In Conventional Examples 1 and 2, the Cu plate and the W plate were not bonded. This is because the Sn-based solder and the Ag brazing material do not have wettability with respect to the W plate. In Conventional Example 3, the Cu plate and the W plate were bonded by adding Ti to the Ag brazing material, and the thermal conductivity of the bonding member was 178 W/m·K. However, when a heat cycle test was conducted, there was no member corresponding to the balance Cu electrode at the lower part, and the bonded portion was peeled off due to the bimetal effect. In Conventional Example 4, since no electric current flows through the silicone resin, it was impossible to perform measurement using a sigma tester. However, in the heat cycle test, the measurement using a sigma tester was performed as a precaution and resulted in peeling of the bonded portion. In Conventional Example 6, before the test, the thermal conductivity was 35 to 65 W/m K and the resin was absent, so that the characteristics were unstable, and the upper part of the bonding member was hollowed after the test. As described above, in Conventional Examples 1 to 6, it was not possible to obtain a bonding member that satisfies the requirement of not being damaged due to a heat cycle test and having a thermal conductivity of 30 W/m·K or more.

Next, Examples and Comparative Examples of the bonding member according to the present invention will be described. Also in Examples and Comparative Examples, the Cu plate and the W plate (both have a diameter of 20 mm and a thickness of 1 mm) were bonded, and the thickness of all the bonding members was 100 µm. The description of the volume fraction is the same as in Conventional Examples. For example, the description of a volume fraction of 70 vol% is that there are voids of 30 vol% inside the bonding member.

The configurations and evaluation results of Examples 1 to 13 and Comparative Examples 1 and 2 are shown in Table 2.

**[Table 2]**

| | No | Foil type | Bonding conditions | Foil thickness and number | Volume fraction (vol%) | Guide | Thermal conductivity after test (W/m·K) |
|---|---|---|---|---|---|---|---|
| Example | 1 | Ag | 25 °C, 10 MPa | 1 µm × 70 sheets | 70 | Presence | 33 |
| | 2 | Ag | 250 °C, 10 MPa | 1 sheet of 50 µm foil on each of upper side and lower side of 10 µm foil | 70 | Presence | 45 |
| | 3 | Ag | 250 °C, 10 MPa | 1 µm × 75 sheets | 75 | Presence | 158 |
| | 4 | Ag | 250 °C, 10 MPa | 1 µm × 80 sheets | 80 | Presence | 160 |
| | 5 | Ag | 250 °C, 10 MPa | 10 µm × 8 sheets | 80 | Absence | 170 |
| | 6 | Ag | 250 °C, 10 MPa | 40 µm × 2 sheets | 80 | Absence | 105 |
| | 7 | Ag | 250 °C, 10 MPa | 1 µm × 85 sheets | 85 | Absence | 205 |
| | 8 | Ag | 250 °C, 10 MPa | 1 µm × 95 sheets | 95 | Absence | 250 |
| | 9 | Cu | 250 °C, 10 MPa | 1 µm × 75 sheets | 75 | Absence | 133 |
| | 10 | Al | 250 °C, 10 MPa | 1 µm × 75 sheets | 75 | Absence | 89 |
| | 11 | Sn | 220 °C, 10 MPa | 1 µm × 75 sheets | 75 | Absence | 55 |
| | 12 | Ag/Sn | 250 °C, 10 MPa | Alternately layering 37 1 µm Al foils and 38 1 µm Sn foils | 75 | Absence | 111 |
| | 13 | Ag | 250 °C, 10 MPa | 47 µm × 2 sheets | 94 | Absence | 44 |
| Comparative Example | 1 | Ag | 250 °C, 10 MPa | 95 µm × 1 sheet | 95 | Presence | Peeling |
| | 2 | Ag | 250 °C, 10 MPa | 1 µm × 60 sheets | 60 | Presence | Peeling |

In Example 1, a laminate of 70 Ag foils disposed between a Cu plate and a W plate is disposed in the hole in the center of the second member, and the second member was sandwiched by the first members from the upper and lower sides to produce a test piece by applying a pressure of 10 MPa in a non-oxidizing atmosphere and at room temperature. In Examples 2 to 13 and Comparative Examples 1 and 2, a test piece was produced by heating to 250 °C in a non-oxidizing atmosphere and applying a pressure of 10 MPa. In Examples 3 and 13, the second member (a member in which a hole having a diameter of 20 mm is formed in the central portion, a guide member surrounding a peripheral portion of the sample) is not used, and a test piece was produced in which the upper and lower sides of the sample were sandwiched by the first members (an alumina plate having a 40 mm square and a thickness of 2 mm). In Example 12, a foil of Ag having a high melting point (thickness: 1 µm) and a foil of Sn having a low melting point (thickness: 1 µm) were alternately layered, and the foils of Sn were partially melted and bonded to the Ag foils.

In all of Examples 1 to 13, the bonded portion was not damaged due to the heat cycle test. In addition, the thermal conductivity after the heat cycle test was higher than 30 W/m·K in all cases. On the other hand, in Comparative Example 1, in which only one Ag foil was used, and Comparative Example 2, in which the volume fraction of the bonding member was 60 vo% (the voids inside the bonding member were 40 vol%), the bonded portion was peeled off due to the heat cycle test. From these results, it can be seen that by using a layered body including at least two or more (that is, a plurality of) metal foils and setting the volume fraction of the bonding member to 70 vol% or more (the void rate of the bonding member is 30 vol% or less), the bonded portion is not damaged due to the heat cycle test, and it is possible to obtain a thermal conductivity of 30 W/m K or more after the heat cycle test. In addition, it can be seen that as the metal foils, one obtained by appropriately combining Ag, Cu, Al, and Sn can be used.

By using the bonding member according to the present invention like a Si or SiC semiconductor device/die bond/Cu electrode/bonding member of the present invention/insulating ceramic substrate/bonding member of the present invention/cooler (order of bonding of respective members and order of bonding members), it is possible to constitute a single-sided cooling type IGBT module using only a minimum number of members to be bonded and a minimum number of (three) bonding members. Although it is a calculated value, this module has heat release performance equal to or higher than that of a double-sided cooling type IGBT module currently being developed for SiC semiconductor devices. By adopting such a single-sided cooling type configuration, it is possible to reduce the number of members to be bonded and also to reduce the number of bonding members as compared with the double-sided cooling type configuration. Of course, when higher heat release performance is required, the bonding member according to the present invention may be used in a double-sided cooling type module. In addition, since an expensive DBC substrate is not used, it is possible to realize an inexpensive, small, and high-performance IGBT module.

The above-described embodiment is merely an example, and can be modified as appropriate in accordance with the spirit of the present invention. In the above Examples, metal foils made of Ag, Cu, and Sn are used, but the same effects can be obtained even when other metals having thermal conductivity and Young's modulus equivalent to those of Ag, Cu, and Sn are used. Including such metals, by layering a plurality of foils made of, for example, Au, Ag, Cu, Al, Ni, Sn, Zn, Mg, Pb, and an alloy of two or more of these metals, it is possible to obtain a bonding member having characteristics similar to those of Examples above. Which metal foil is used can be appropriately determined in consideration of flexibility, linear expansion coefficient, thermal conductivity, cost, and the like required for the bonding member.

### REFERENCE SIGNS LIST

1... Bonded Body
10... Layered Body
11... Metal Foil
12... Void
20, 30... Member to be Bonded

## Claims

1. A bonding member comprising:
a layered body formed by layering a plurality of foils made of a material selected from Au, Ag, Cu, Al, Ni, Sn, Zn, Mg, Pb, and an alloy of two or more of Au, Ag, Cu, Al, Ni, Sn, Zn, Mg and Pb, the layered body having voids of 5 vol% or more and 30 vol% or less inside,
wherein thermal conductivity after a heat cycle test in which heating to 200 °C and cooling to 25 °C are repeated 300 times is 30 W/m·K or more.

2. The bonding member according to claim 1, wherein the plurality of foils each have a thickness of 0.1 µm or more and 100 µm or less.

3. The bonding member according to claim 1 or 2, wherein the layered body has a thickness of 3 µm or more and 500 µm or less.

4. A bonded body comprising two members to be bonded selected from a metal member, a ceramic member, and a resin member, the two members to be bonded being bonded with the bonding member according to any one of claims 1 to 3.

5. A bonded body comprising a metal electrode substrate on which a power semiconductor device is mounted and a ceramic insulating substrate or a resin insulating substrate, the metal electrode substrate and the ceramic insulating substrate or the resin insulating substrate being bonded with the bonding member according to any one of claims 1 to 3.

6. A bonded body comprising a ceramic insulating substrate or a resin insulating substrate and a cooler, the ceramic insulating substrate or the resin insulating substrate and the cooler being bonded with the bonding member according to any one of claims 1 to 3.
